# EUROPÄISCHE PATENTANMELDUNG

(11) **EP 3 435 421 A1**
(43) Veröffentlichungstag der Anmeldung: **30.01.2019**
(21) Anmeldenummer: 18177473.8
(22) Anmeldetag: 13.06.2018
(51) Int. Cl.: H01L 29/78, H01L 29/06, H01L 29/20, H01L 29/417, H01L 29/66

(54) **VERFAHREN ZUM HERSTELLEN EINER VERTIKALEN FELDEFFEKTTRANSISTORSTRUKTUR UND ENTSPRECHENDE VERTIKALE FELDEFFEKTTRANSISTORSTRUKTUR**

(30) Priorität: 26.07.2017 DE 102017212871
(71) Anmelder: Robert Bosch GmbH, 70442 Stuttgart (DE)
(72) Erfinder: Mansfeld, Sebastian, 71272 Renningen (DE); Baringhaus, Jens, 71069 Sindelfingen (DE)

(57) **Zusammenfassung**

Die Erfindung betrifft ein Verfahren zum Herstellen einer vertikalen Feldeffekttransistorstruktur und eine entsprechende vertikale Feldeffekttransistorstruktur. Die vertikale Feldeffekttransistorstruktur ist ausgestattet mit einem Substrat (1; 1a, 1b), welches mindestens eine Ausnehmung (11) aufweist, in welche ein Drain-Kontaktbereich (10) eingebracht ist; einer auf dem Substrat (1; 1a, 1b) epitaktisch aufgebrachten ersten GaN-Schicht (2) eines ersten Leitfähigkeitstyps (n), welche einen Drainbereich bildet, der vom Drain-Kontaktbereich (10) elektrisch kontaktiert ist; einem auf der ersten GaN-Schicht (2) aufgebrachten Bereich einer zweiten GaN-Schicht (3) des zweiten Leitfähigkeitstyps (p); einem auf der zweiten GaN-Schicht (3) aufgebrachten Bereich einer dritten GaN-Schicht (4) des ersten Leitfähigkeitstyps (n), welche einen Sourcebereich bildet; einem auf der dritten GaN-Schicht (4) ausgebildeten Source-Kontaktbereich (8); und einem Gate-Kontakt (6), welcher über einem Teilbereich der zweiten GaN-Schicht (3) elektrisch isoliert davon durch einen Gateisolator (5) ausgebildet ist, wobei der Teilbereich einen Kanalbereich (K) bildet.

## Beschreibung

Die Erfindung betrifft ein Verfahren zum Herstellen einer vertikalen Feldeffekttransistorstruktur und eine entsprechende vertikale Feldeffekttransistorstruktur.

### Stand der Technik

Feldeffekttransistoren (FETs) auf Basis von Galliumnitrid (GaN) werden mittels zweier etablierter Konzepte hergestellt.

High Electron Mobility Transistoren (HEMT/2DEGFET) nutzen die grenzflächeninduzierte Ausbildung eines hochleitfähigen zweidimensionalen Elektronengases (2DEG). Aus dem Stand der Technik sind HEMTs auf GaN-Basis bekannt, welche als laterale Bauelemente ausgestaltet sind. Die Baugröße derartiger lateraler Elemente nimmt jedoch stärker mit deren Leistung zu als bei Elementen mit vertikaler Bauweise.

Konventionelle GaN-HEMTs sind in der Regel selbstleitend (im Gegensatz zu selbstsperrenden Transistoren). Bei sicherheitskritischen Anwendungen, beispielsweise im Automotive-Bereich, sind jedoch häufig selbstsperrende Schaltelemente wünschenswert.

Vertikale FETs auf GaN-Basis können bereits gebaut werden. Das Herstellungsverfahren ist aber sehr kostenintensiv, da hier für homoepitaktisches Wachstum teure GaN-Substrate benötigt werden.

Die DE 10 2013 210 814 A1 offenbart ein Verfahren zum Herstellen eines Transistors mit hoher Elektronenbeweglichkeit, aufweisend die Schritte: a) Bereitstellen einer HEMT-Struktur; b) Aufbringen einer dielektrischen Schicht auf die HEMT-Struktur; c) Aufbringen einer Gateschutzschicht auf die dielektrische Schicht in einem für das Gate vorgesehenen Bereich; d) Öffnen der ersten dielektrischen Schicht und Ausbilden von Ohmschen Kontakten in den Bereichen von Source und Drain; e) Abscheiden und Strukturieren von Passivierungsschichten, wobei das Strukturieren mittels Trockenätzens mit Ätzstopp auf der Gateschutzschicht durchgeführt wird; f) Ausbilden einer Struktur für das Gate durch Strukturieren der Passivierungsschichten und selektives Entfernen der Gateschutzschicht; und g) Abscheiden und Strukturieren von Anschlussmetallisierungen aller Elektroden des Leistungstransistors.

Die DE 10 2015 114 791 A1 offenbart ein Verfahren zur Herstellung eines Feldeffekttransistors mit einer hohen Elektronenbeweglichkeit, wobei das Verfahren aufweist: Herstellen eines Puffergebiets mit einem abgestuften lateralen Profil und einer darin angeordneten vergrabenen Feldplatte, wobei das abgestufte laterale Profil einen ersten, einen zweiten und einen dritten Querschnitt des Puffergebiets aufweist, wobei der erste Querschnitt dicker als der dritte Querschnitt ist und die vergrabene Feldplatte aufweist und der zweite Querschnitt zwischen dem ersten und dem dritten Querschnitt angeordnet ist und mit dem ersten und dem dritten Querschnitt schräge Winkel bildet; und Herstellen eines Barrieregebiets entlang des abgestuften lateralen Profils des Puffergebiets, wobei das Barrieregebiet von der vergrabenen Feldplatte durch einen Abschnitt des Puffergebiets getrennt ist; wobei das Puffergebiet aus einem ersten Halbleitermaterial hergestellt wird und das Barrieregebiet aus einem zweiten Halbleitermaterial hergestellt wird und das erste und das zweite Halbleitermaterial unterschiedliche Bandlücken aufweisen, so dass ein elektrisch leitender Kanal, der ein zweidimensionales Ladungsträgergas aufweist, infolge piezoelektrischer Effekte an einer Grenzfläche zwischen dem Puffer- und dem Barrieregebiet entsteht.

Die US 6 818 061 B2 beschreibt ein Verfahren zum Bilden einer GaN-Schicht auf einem Si-Substrat.

Die US 5 610 085 A offenbart einen vertikaler Feldeffekttransistor und einschlägiges Herstellungsverfahren mit vergrabenen Gates und epitaktischer Überwachsung. Die vertikalen Feldeffekttransistorelemente bestehen aus einer auf einem Germaniumsubstrat aufgewachsenen III-V-Halbleiterverbindung.

### Offenbarung der Erfindung

Die Erfindung schafft eine vertikale Feldeffekttransistorstruktur nach Anspruch 1 und ein Verfahren zum Herstellen einer vertikalen Feldeffekttransistorstruktur nach Anspruch 9.

Bevorzugte Weiterbildungen sind Gegenstand der jeweiligen Unteransprüche.

### Vorteile der Erfindung

Die der vorliegenden Erfindung zugrunde liegende Idee besteht darin, eine Leistungs-Feldeffekttransistorstruktur auf Galliumnitridbasis durch Epitaxie zur Verfügung zu stellen.

GaN wird hierbei auf ein Substrat epitaktisch aufgebracht. So kann hier die Wahl des Substrates auf Basis ökonomischer Aspekte erfolgen. Die vertikale Bauweise erlaubt für eine Vereinigung von gutem Leistungs- und Miniaturisierungsverhalten.

Insbesondere ist es erfindungsgemäß möglich, heteroepitaktisches Wachstum zur Erzeugung einer vertikalen GaN-FET-Struktur auf einem preisgünstigen Substrat, wie beispielsweise Silizium, einzusetzen.

Gemäß einer bevorzugten Weiterbildung wird der Schritt ausgeführt: Erzeugen einer weiteren Ausnehmung in der zweiten und dritten GaN-Schicht, wobei der Gateisolator im Bereich der weiteren Ausnehmung aufgebracht wird. Dies hat den Vorteil, dass selbst bei Einsatz vollflächiger GaN-Schichten das Gate in Nähe der zweiten GaN-Schicht ausgebildet werden kann, was ein gutes Schalt- und Leistungsverhalten gewährleistet.

Gemäß einer bevorzugten Weiterbildung hat die Ausnehmung eine quaderförmige oder v-förmige Form. In Folge kann die Ausnehmung mit einfachen Mitteln erzeugt werden und die Stärke der Kopplung des Gates an die zweite GaN-Schicht modifiziert werden.

Gemäß einer bevorzugten Weiterbildung wird der Schritt ausgeführt: Bilden eines mehrschichtigen Substrates. Dadurch können unerwünschte Grenzflächeneffekte vermieden oder reduziert werden. Dadurch kann auch eine folgende GaN-Heteroepitaxie verbessert werden, beispielsweise durch Vermeidung oder Reduktion von Gitterverspannungen.

Gemäß einer bevorzugten Weiterbildung weist das Substrat ein Siliziumsubstrat und mindestens eine Schicht Betasiliziumcarbid und/oder Aluminiumgalliumnitrid und/oder Aluminiumnitrid auf. Siliziumsubstrate haben eine hohe Verfügbarkeit und Wirtschaftlichkeit, und es können Kosten eingespart werden. Die weiteren Schichten sorgen für ein Matching mit dem GaN-Drainbereich.

Gemäß einer bevorzugten Weiterbildung weist das Substrat ein Siliziumsubstrat und mindestens eine Schicht auf.

Gemäß einer bevorzugten Weiterbildung wird der Schritt ausgeführt: Rückschleifen des Substrates vor dem Bilden der Ausnehmung für den Drain-Kontaktbereich. So kann die Feldeffekttransistorstruktur besser miniaturisiert werden.

### Kurze Beschreibung der Zeichnungen

Weitere Merkmale und Vorteile der vorliegenden Erfindung werden nachfolgend anhand von Ausführungsformen mit Bezug auf die Figuren erläutert.

Es zeigen:
Fig. 1a) eine schematische Darstellung einer vertikalen Feldeffekttransistorstruktur gemäß einer ersten Ausführungsform der vorliegenden Erfindung;
Fig. 1b) eine schematische Darstellung einer vertikalen Feldeffekttransistorstruktur gemäß einer zweiten Ausführungsform der vorliegenden Erfindung;
Fig. 1c) eine schematische Darstellung einer vertikalen Feldeffekttransistorstruktur gemäß einer dritten Ausführungsform der vorliegenden Erfindung; und
Fig. 2a)-g) schematische Darstellungen eines Verfahrens zur Herstellung einer vertikalen Feldeffekttransistorstruktur gemäß der ersten Ausführungsform der vorliegenden Erfindung.

### Ausführungsformen der Erfindung

In den Figuren bezeichnen gleiche Bezugszeichen gleiche bzw. funktionsgleiche Elemente.

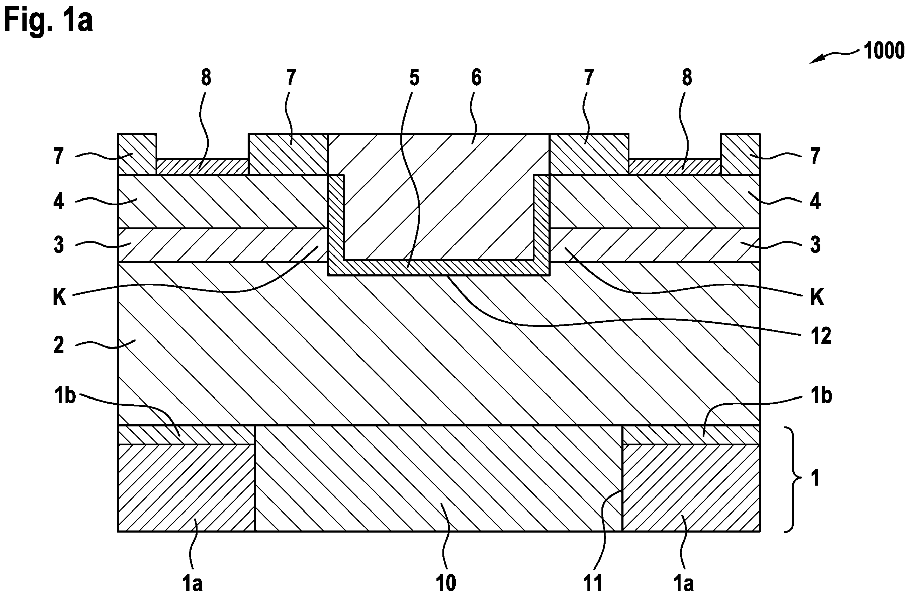

Fig. 1a) ist eine schematische Darstellung einer vertikalen Feldeffekttransistorstruktur gemäß einer ersten Ausführungsform der vorliegenden Erfindung.

Die Feldeffekttransistorstruktur 1000 umfasst ein mehrschichtiges Substrat 1, bestehend aus einem Substrat la und einer oder mehreren aufgebrachten Schichten 1b. Das Substrat la ist beispielweise ein Siliziumsubstrat, wie es durch einen Siliziumwafer zur Verfügung gestellt wird. Als Schicht 1b wird beispielweise eine Schicht Betasiliziumcarbid aufgebracht, gefolgt von einer oder mehreren Schichten aus Aluminiumgalliumnitrid und/oder Aluminiumnitrid.

Auf dem Substrat 1 befinden sich eine erste, zweite und dritte Galliumnitridschicht 2, 3, 4. Hierbei sind die erste Galliumnitridschicht 2 sowie die dritte Galliumnitridschicht 4 vom ersten Leitfähigkeitstyp und die zweite Galliumnitridschicht 3 ist vom zweiten Leitfähigkeitstyp. Im vorliegenden Beispiel ist der erste Leitfähigkeitstyp n und der zweite Leitfähigkeitstyp p (npn-Transistor). Es kann aber auch umgekehrt der erste Leitfähigkeitstyp p und der zweite Leitfähigkeitstyp n sein (pnp-Transistor).

Die erste Galliumnitridschicht 2 ist eine epitaktische Galliumnitridschicht. Die zweite und dritte Galliumnitridschicht 3, 4 können ebenfalls epitaktische Galliumnitridschichten sein, es können aber auch andere Verfahrensweisen oder Kombinationen von Verfahrensweisen zur Schichterzeugung zum Einsatz gebracht werden. Insbesondere kann dabei auch die Dotierung der zweiten und dritten Galliumnitridschicht 3, 4 mit anderen Verfahren wie beispielsweise Ionenimplantation erzeugt werden.

Durch einen Drain-Kontaktbereich 10, der in einer rückseitigen Ausnehmung 11 des Substrats 1 vorgesehen ist, wird die erste Galliumnitridschicht 3 durch das Substrat 1 hindurch elektrisch kontaktiert.

Ein Gate-Kontakt 6 befindet sich in einer vorderseitigen Ausnehmung 12 in dem Stapel der ersten, zweiten und dritten Galliumnitridschicht 2, 3, 4. Bei der ersten Ausführungsform hat die vorderseitige Ausnehmung 12 die Form eines Rechtecks, aber auch eine zylinderförmige Ausnehmung 12 o.ä. wäre denkbar.
Ein Gateisolator 5, z.B. eine Gateoxid, in der Ausnehmung 12 isoliert dabei den Gate-Kontakt 6 elektrisch von den der ersten, zweiten und dritten Galliumnitridschicht 2, 3, 4.

Durch die Ausnehmung 12 ist es bei der ersten Ausführungsform möglich, dass der Gate-Kontakt 6 lateral in Nähe der zweiten Galliumnitridschicht 3, elektrisch isoliert durch den Gateisolator 5, angeordnet ist. Dadurch kann ein guter Stromfluss im Kanalbereich K des eingeschalteten Transistors und damit eine hohe Transistorleistung erreicht werden.

Ein Source-Kontaktbereich 8 ist auf der dritten Galliumnitridschicht 4 ausgebildet. Beispielsweise kann der Source-Kontaktbereich 8 mit einer ringförmigen Topologie um den Gate-Kontakt 6 ausgebildet sein. Weitere elektrische Isolatorbereiche 7 können zwecks elektrischer Isolation an den Rändern des Source-Kontaktbereiches 8, insbesondere auch zwischen Source-Kontaktbereich 8 und Gate-Kontakt 6, eingesetzt werden.

Die Feldeffekttransistorstruktur 1000 gemäß der ersten Ausführungsform der vorliegenden Erfindung hat das folgende Schaltverhalten. Bei positivem Potenzial des Gate-Kontaktes 6 entsteht im Falle des npn-Transistors in der zweiten Schicht 3, insbesondere in denen an das Gate angrenzenden Gebieten, der Kanalbereich K zwischen dem Source-Kontaktbereich 8 und dem Drain-Kontaktbereich 10, welcher Elektronentransport ermöglicht. Analog hierzu entsteht bei negativem Potenzial des Gate-Kontaktes 6 im Falle eines pnp-Transistors in der zweiten Schicht 3, insbesondere in denen an das Gate angrenzenden Gebieten, ein Kanal K zwischen Source-Kontaktbereich 8 und Drain-Kontaktbereich 10, welcher Transport von Defektelektronen ermöglicht.

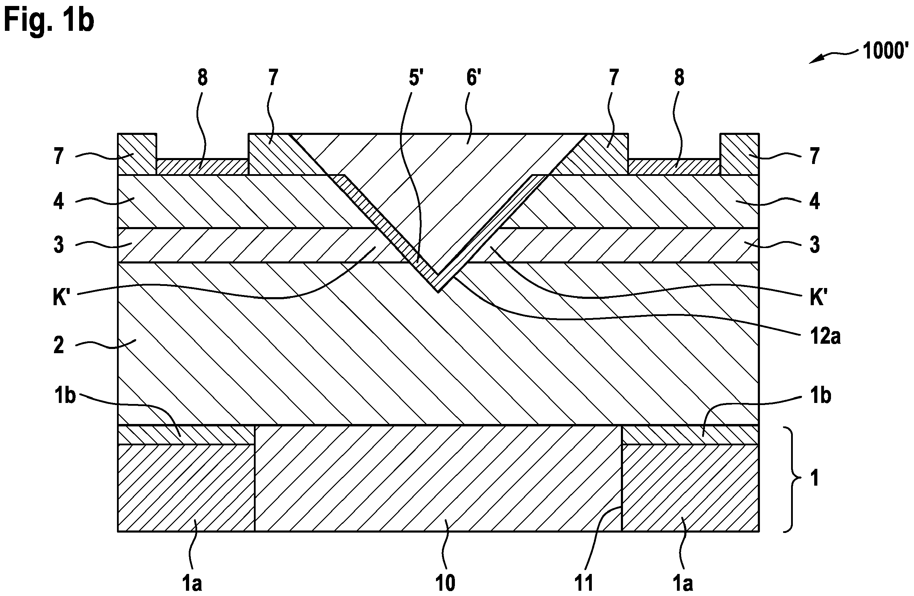

Fig. 1b) ist eine schematische Darstellung einer vertikalen Feldeffekttransistorstruktur gemäß einer zweiten Ausführungsform der vorliegenden Erfindung.

Im Folgenden werden lediglich Unterschiede der Feldeffekttransistorstruktur 1000' gemäß der zweiten Ausführungsform gegenüber der Feldeffekttransistorstruktur 1000 gemäß der ersten Ausführungsform dargelegt. Im Hinblick auf identische Merkmale der beiden Ausführungsformen wird auf die Beschreibung der Figur 1a) verwiesen.

Ein Gate-Kontakt 6' befindet sich in einer vorderseitigen Ausnehmung 12a in dem Stapel der ersten, zweiten und dritten Galliumnitridschicht 2, 3, 4. Bei der zweiten Ausführungsform hat die Ausnehmung 12a eine v-förmige Form. Es kann sich dabei daher bei der zweiten Ausführungsform um eine Ausnehmung 12a mit konischer Form handeln, aber auch andere Formen mit v-förmigen Querschnitt als Ausnehmung 12a wären denkbar.
Ein Gateisolator 5' stellt elektrische Isolation für den Gate-Kontakt 6' bereit, welcher darüber angeordnet ist. Der Kanalbereich K' ist schräg lateral zur zweiten Galliumnitridschicht 3 angeordnet.

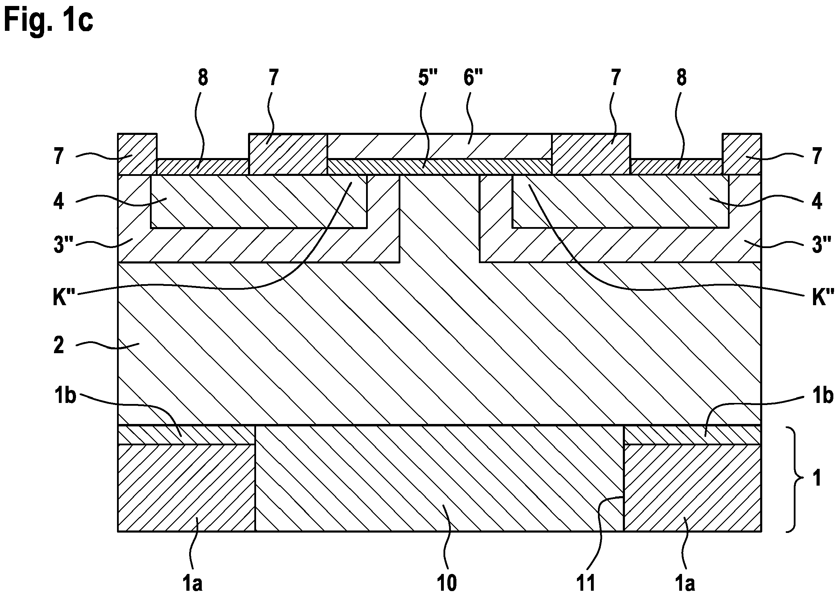

Fig. 1c) ist eine schematische Darstellung einer vertikalen Feldeffekttransistorstruktur gemäß einer dritten Ausführungsform der vorliegenden Erfindung.
Im Folgenden werden lediglich Unterschiede der Feldeffekttransistorstruktur 1000" gemäß der dritten Ausführungsform gegenüber der Feldeffekttransistorstruktur 1000 gemäß der ersten Ausführungsform dargelegt. Im Hinblick auf identische Merkmale der beiden Ausführungsformen wird auf die Beschreibung der Figur 1a) verwiesen.

Die dritte Galliumnitridschicht 4 ist, wie in Fig. 1c) im Querschnitt dargestellt, wannenförmig ausgebildet.

Bei der dritten Ausführungsform verfügt die Feldeffekttransistorstruktur 1000" über keine Ausnehmung für den Gate-Kontakt 6". Vielmehr ist der Gate-Kontakt 6", durch einen Gate-Isolator 5" elektrisch isoliert, oberflächlich auf den Stapel der ersten zweiten und dritten Galliumnitidschicht 2, 3", 4 aufgebracht.

Durch die wannenförmige Ausbildung der dritten Galliumnitridschicht 4 ist es bei der dritten Ausführungsform auch ohne eine Ausnehmung möglich, dass der Gate-Kontakt 6 in Nähe der zweiten Schicht 3" angeordnet ist. Der Gateisolator 5" trennt den Gate-Kontakt 6" von der zweiten Schicht 3". Dadurch kann ein guter Stromfluss im Kanal K" des geschalteten Transistors und damit eine hohe Transistorleistung erreicht werden.

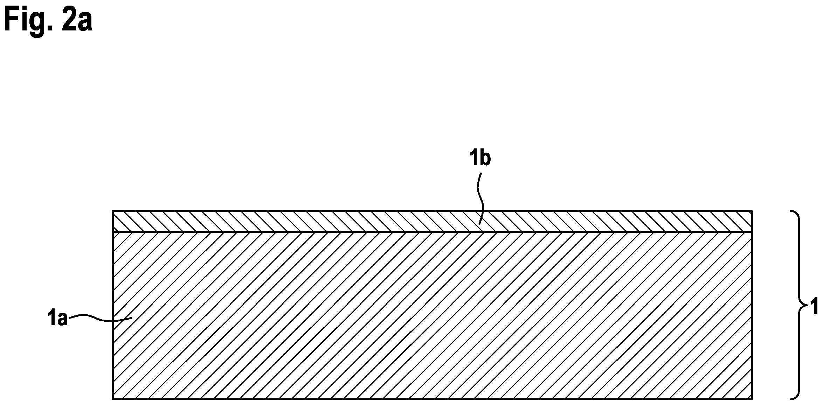

Fig. 2a)-g) sind schematische Darstellungen eines Verfahrens zur Herstellung einer vertikalen Feldeffekttransistorstruktur gemäß der ersten Ausführungsform der vorliegenden Erfindung.

Wie in Fig. 2a) dargestellt kommt bei dem Verfahren zur Herstellung einer vertikalen Feldeffekttransistorstruktur gemäß der ersten Ausführungsform der vorliegenden Erfindung ein Substrat la zum Einsatz. Beispielsweise ist das Substrat la ein Siliziumsubstrat in Form eines Siliziumwafers. Auf das Substrat la können hierbei eine oder mehrere zusätzliche Schichten 1b aufgebracht werden. Als zusätzliche Schichten 1b kann beispielsweise zunächst eine Schicht Betasiliziumcarbid heteroepitaktisch aufgewachsen werden, gefolgt von einem Wachstum einer Mehrzahl an Aluminiumgalliumnitrid- und/oder Aluminiumnitridschichten.

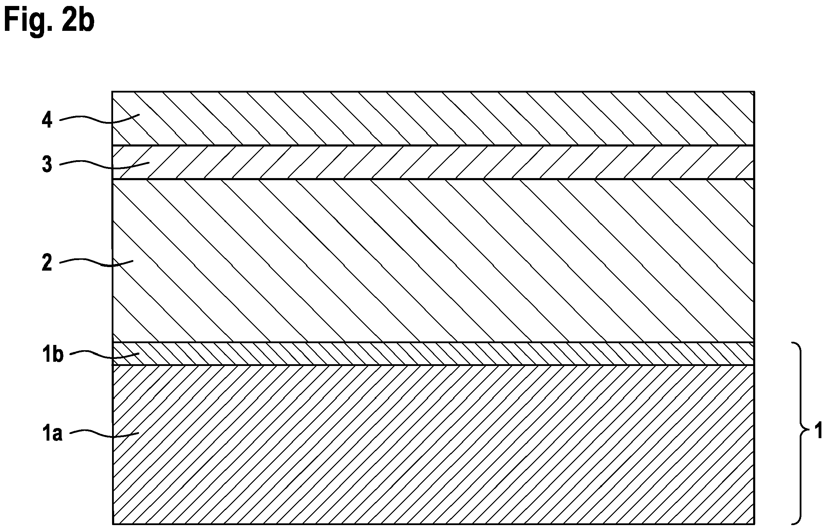

Wie in Fig. 2b) dargestellt werden anschließend die erste, zweite und dritte Galliumnitridschichten 2, 3, 4 auf das Substrat 1 aufgebracht. Hierbei sind die erste Galliumnitridschicht 2 sowie die dritte Galliumnitridschicht 4 vom ersten Leitfähigkeitstyp n, und die zweite Galliumnitridschicht 3 ist vom zweiten Leitfähigkeitstyp p.

In einem Beispiel ist der erste Leitfähigkeitstyp n und der zweite Leitfähigkeitstyp p (npn-Transistor). Es kann aber auch umgekehrt der erste Leitfähigkeitstyp p und der zweite Leitfähigkeitstyp n sein (pnp-Transistor). Die Galliumnitridschichten 2, 3, 4 sind also Schichten, welche durch entsprechende Dotierung p- bzw. n-leitend sind.

Die erste Galliumnitridschicht 2 wird durch epitaktisches Wachstum aufgebracht. Die zweite und dritte Galliumnitridschicht 3, 4 können ebenfalls durch epitaktisches Wachstum aufgebracht werden, es können aber auch andere Verfahrensweisen oder Kombinationen von Verfahrensweisen zum Herstellen angewendet werden werden. Insbesondere kann dabei auch die Dotierung der zweiten und dritten Galliumnitridschicht 3, 4 mit dem zweiten bzw. ersten Leitfähigkeitstyp mit anderen Verfahren, wie beispielsweise Ionenimplantation, erzeugt werden.

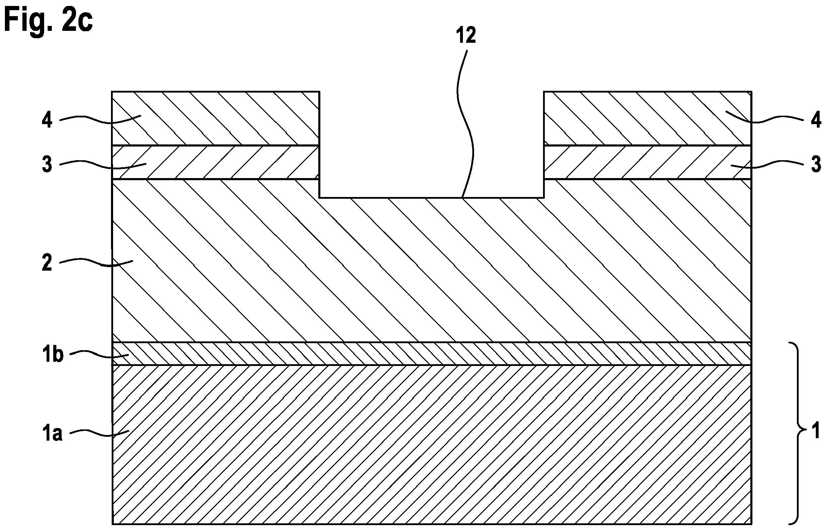

In Fig. 2c) ist dargestellt, wie im folgenden Verfahrensschritt die vorderseitige Ausnehmung 12 in dem Stapel der ersten, zweiten und dritte Galliumnitridschicht 2, 3, 4 erzeugt wird. Bei der ersten Ausführungsform hat die vorderseitige Ausnehmung 12 den Querschnitt eines Rechtecks. Die Herstellung erfolgt in einem üblichen Lithographie-/Ätzschritt.

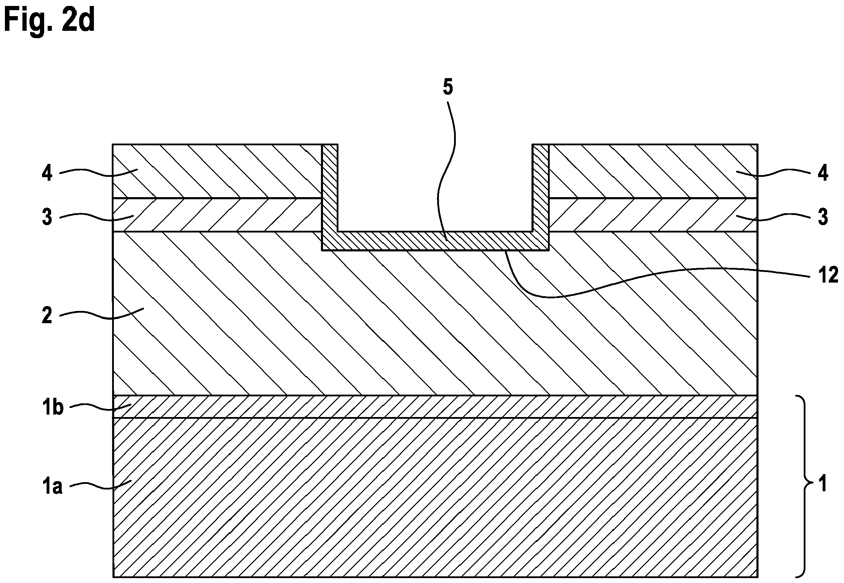

Mit Bezug auf Fig. 2d) wird im nächsten Verfahrensschritt der Gateisolator 5, z.B. ein Gateoxid, in die Ausnehmung 12 eingebracht, z.B. durch Abscheidung und anschließende Strukturierung. Der Gateisolator 5 isoliert das Gate elektrisch von der ersten, zweiten und dritte Galliumnitridschicht 2, 3, 4.

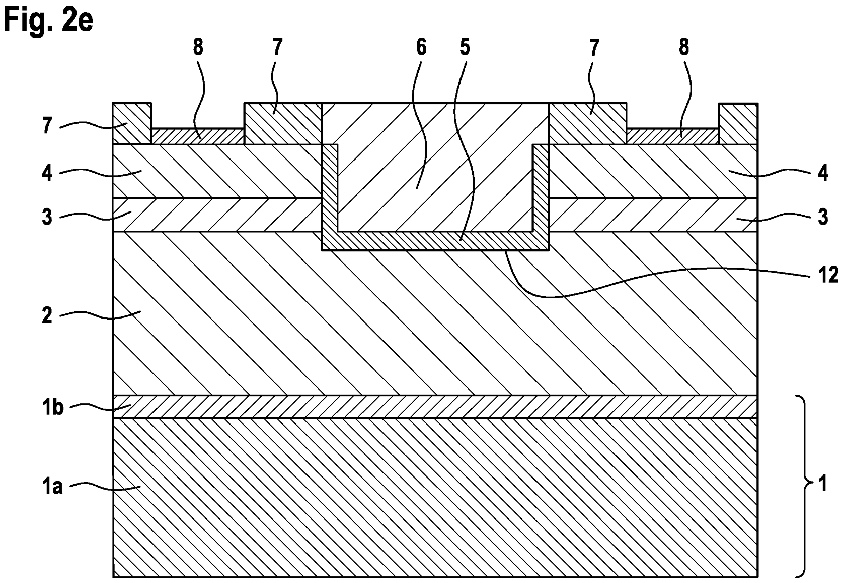

Mit Bezug auf Fig. 2e) wird im einem weiteren Verfahrensschritt der Gate-Kontakt 6 in die Ausnehmung 12 eingebracht. Dabei sorgt der Gateisolator 5 für eine elektrische Isolation der der ersten, zweiten und dritte Galliumnitridschicht 2, 3, 4 vom Gate-Kontakt 6.

Desweiteren wird mit Bezug auf Fig. 2e) der Source-Kontaktbereich 8 auf der dritten Galliumnitridschicht 4 ausgebildet. Beispielsweise kann der Source-Kontaktbereich 8 mit einer ringförmigen Topologie um den Gate-Kontakt 6 ausgebildet sein. Weitere elektrische Isolatorbereiche 7 können zwecks elektrischer Isolation an den Rändern des Source-Kontaktbereiches 8, insbesondere auch zwischen Source-Kontaktbereich 8 und Gate-Kontakt 6, eingesetzt werden.

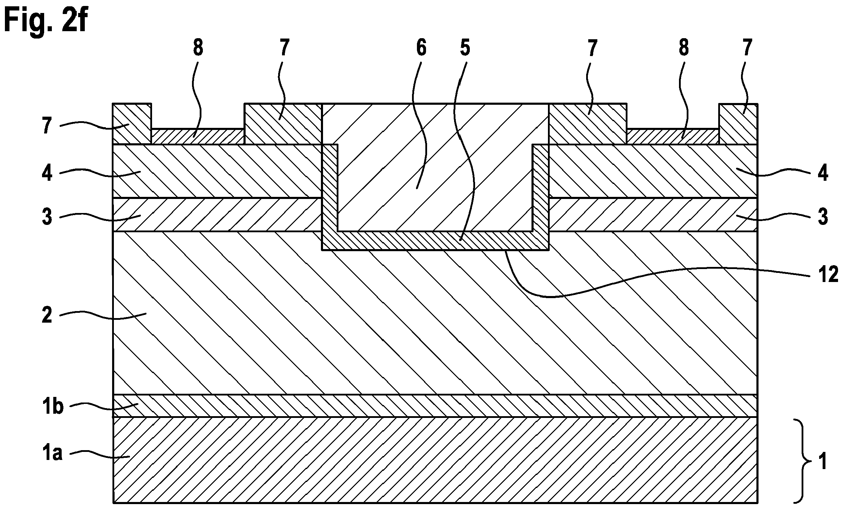

Fig. 2f) zeigt einen Verfahrensschritt des Rückschleifens (Backgrinding) des Substrates 1. Dabei wird ein Teil des Substrates la abgetragen. Infolge dieses Prozesses wird die Dicke des Substrates reduziert und dadurch die Feldeffekttransistorstruktur dünner und kompakter.

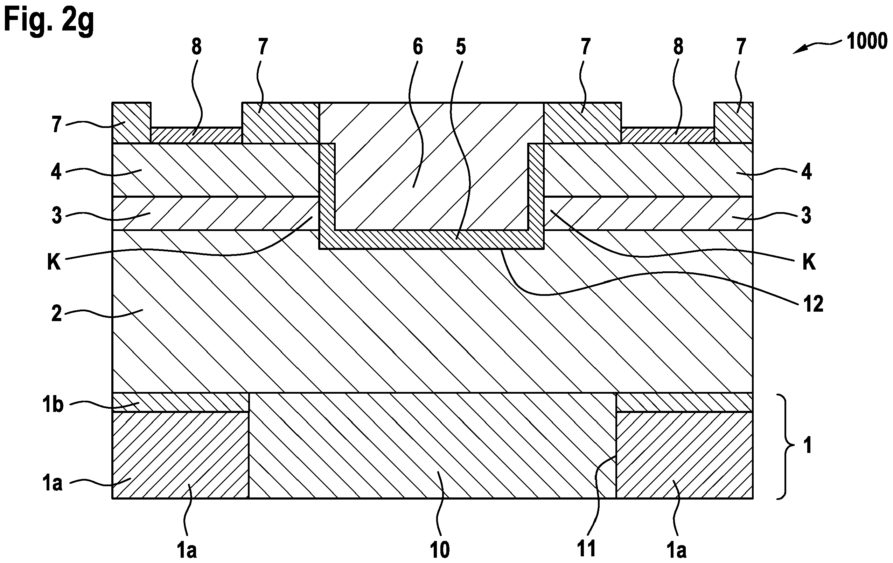

Mit Bezug auf Fig. 2g) wird in das rückgeschliffene Substrat 1 die rückseitige Ausnehmung 11 eingebracht. In diese Ausnehmung 11 wird sodann ein Drain-Kontaktbereich 10 eingebracht, z.B. durch Abscheidung und Strukturierung. Die Ausnehmung 11 dringt durch das Substrat 1 vollständig hindurch, sodass die erste Galliumnitridschicht 2 durch den Drain-Kontaktbereich 10 elektrisch kontaktiert wird.

Als Resultat der Verfahrensschritte entsteht die Feldeffekttransistorstruktur 1000 gemäß der ersten Ausführungsform.

Für ein Verfahren zur Herstellung einer Feldeffekttransistorstruktur 1000' oder 1000" gemäß der zweiten oder dritten Ausführungsform der vorliegenden Erfindung sind die Teilschritte des Verfahrens hinsichtlich der vorderseitigen Strukturierung entsprechend zu modifizieren.

Obwohl die vorliegende Erfindung anhand bevorzugter Ausführungsbeispiele beschrieben wurde, ist sie darauf nicht beschränkt. Insbesondere sind die genannten Materialien und Topologien nur beispielhaft und nicht auf die erläuterten Beispiele beschränkt. Auch sind die dargestellten Geometrien nur beispielhaft und können bedarfsweise beliebig variiert werden.

## Patentansprüche

1. Vertikale Feldeffekttransistorstruktur (1000; 1000'; 1000") mit:
einem Substrat (1; 1a, 1b), welches mindestens eine Ausnehmung (11) aufweist, in welche ein Drain-Kontaktbereich (10) eingebracht ist;
einer auf dem Substrat (1; 1a, 1b) epitaktisch aufgebrachten ersten GaN-Schicht (2) eines ersten Leitfähigkeitstyps (n), welche einen Drainbereich bildet, der vom Drain-Kontaktbereich (10) elektrisch kontaktiert ist;
einem auf der ersten GaN-Schicht (2) aufgebrachten Bereich einer zweiten GaN-Schicht (3) des zweiten Leitfähigkeitstyps (p);
einem auf der zweiten GaN-Schicht (3) aufgebrachten Bereich einer dritten GaN-Schicht (4) des ersten Leitfähigkeitstyps (n), welche einen Sourcebereich bildet;
einem auf der dritten GaN-Schicht (4) ausgebildeten Source-Kontaktbereich (8); und
einem Gate-Kontakt (6), welcher über einem Teilbereich der zweiten GaN-Schicht (3) elektrisch isoliert davon durch einen Gateisolator (5) ausgebildet ist, wobei der Teilbereich einen Kanalbereich (K; K'; K") bildet.

2. Vertikale Feldeffekttransistorstruktur (1000; 1000') nach Anspruch 1, wobei der Gate-Kontakt (6) in eine weitere Ausnehmung (12; 12a) der ersten, zweiten und dritten GaN-Schicht (2; 3; 4), durch den Gateisolator (5) elektrisch isoliert, eingebracht ist.

3. Vertikale Feldeffekttransistorstruktur (1000; 1000') nach Anspruch 2, wobei die Ausnehmung (12; 12a) eine quaderförmige oder v-förmige Form hat.

4. Vertikale Feldeffekttransistorstruktur (1000; 1000'; 1000") nach einem der Ansprüche 1 bis 3, wobei der Source-Kontaktbereich (8) ringförmig um den Gate-Kontakt (6) herum ausgebildet ist.

5. Vertikale Feldeffekttransistorstruktur (1000; 1000'; 1000") nach einem der Ansprüche 1 bis 4, wobei die zweite und/oder dritte GaN-Schicht (3; 4) eine durch Implantation von Ionen dotierte GaN-Schicht (3; 4) ist.

6. Vertikale Feldeffekttransistorstruktur (1000; 1000'; 1000") nach einem der Ansprüche 1 bis 5, wobei das Substrat (1; 1a, 1b) mehrschichtig ist.

7. Vertikale Feldeffekttransistorstruktur (1000; 1000'; 1000") nach Anspruch 6, wobei das Substrat (1) ein Siliziumsubstrat (1a) und mindestens eine darauf aufgebrachte die Schicht (1b) aus Betasiliziumcarbid aufweist.

8. Vertikale Feldeffekttransistorstruktur (1000, 1000', 1000") nach Anspruch 6, wobei das Substrat (1) ein Siliziumsubstrat (1a) und mindestens eine darauf aufgebrachte die Schicht (1b) aus Aluminiumgalliumnitrid und/oder Aluminiumnitrid aufweist.

9. Verfahren zur Herstellung einer vertikalen Feldeffekttransistorstruktur (1000; 1000'; 1000") mit den Schritten:
epitaktisches Aufbringen einer ersten GaN-Schicht (2) eines ersten Leitfähigkeitstyps (n) auf ein Substrat (1; 1a, 1b) zur Bildung eines Drainbereiches;
Aufbringen eines Bereiches einer zweiten GaN-Schicht (3) des zweiten Leitfähigkeitstyps (p) auf der ersten GaN-Schicht (2);
Aufbringen eines Bereiches einer dritten GaN-Schicht (4) des ersten Leitfähigkeitstyps (n) auf der zweiten GaN-Schicht (3) zur Bildung eines Sourcebereiches;
Ausbilden eines Source-Kontaktbereiches auf der dritten GaN-Schicht (4);
Aufbringen eines Gateisolators (5) über einem Teilbereich der zweiten GaN-Schicht (3);
Ausbilden des Gate-Kontaktes (6) über dem Gateisolator (5);
Erzeugen einer Ausnehmung (10) im Substrat (1; 1a, 1b); und
Einbringen eines Drain-Kontaktbereiches (10) in die Ausnehmung (11) zur elektrischen Kontaktierung des Drainbereiches.

10. Verfahren nach Anspruch 9, wobei die Schritte ausgeführt werden:
Erzeugen einer weiteren Ausnehmung (12; 12a) in der zweiten und dritten GaN-Schicht (3; 4);
Aufbringen des Gateisolators (5) der Gateisolator (5) im Bereich der weiteren Ausnehmung (12; 12a).

11. Verfahren nach Anspruch 10 oder 11, wobei der Schritt ausgeführt wird:
Bilden eines mehrschichtigen Substrates (1; 1a, 1b).

12. Verfahren nach Anspruch 11, wobei das Substrat (1) ein Siliziumsubstrat (la) und mindestens eine darauf aufgebrachte die Schicht (1b) aus Betasiliziumcarbid aufweist.

13. Verfahren nach Anspruch 11, wobei wobei das Substrat (1) ein Siliziumsubstrat (la) und mindestens eine darauf aufgebrachte die Schicht (1b) aus Aluminiumgalliumnitrid und/oder Aluminiumnitrid aufweist.

14. Verfahren nach einem der Ansprüche 9 - 14, wobei der Schritt ausgeführt wird:
Rückschleifen des Substrates (1; 1a, 1b) vor dem Erzeugen der Ausnehmung (11).
